# EUROPÄISCHE PATENTSCHRIFT

(11) **EP 1 113 712 B1**
(45) Veröffentlichungstag und Bekanntmachung des Hinweises auf die Patenterteilung: **06.05.2015**
(21) Anmeldenummer: 00125929.0
(22) Anmeldetag: 27.11.2000
(51) Int. Cl.: H05K 3/10, H05K 3/46, H01L 21/48

(54) **Verfahren zum Herstellen von Leiterbahnen**
Process for manufacturing conductive lines
Procédé de fabrication de lignes conductrices

(30) Priorität: 27.12.1999 DE 19963281
(43) Veröffentlichungstag der Anmeldung: 04.07.2001
(73) Patentinhaber: Tridonic GmbH & Co KG, 6851 Dornbirn (AT)
(72) Erfinder: Hein, Peter, Dipl.-Ing., 6833 Fraxern (AT)
(74) Vertreter: Rupp, Christian

(56) Entgegenhaltungen:
- US-A- 3 948 706
- US-A- 3 956 052
- US-A- 4 552 615
- US-A- 4 581 098
- PATENT ABSTRACTS OF JAPAN vol. 015, no. 082 (E-1038), 26. Februar 1991 (1991-02-26) & JP 02 299292 A (HITACHI LTD), 11. Dezember 1990 (1990-12-11)
- PATENT ABSTRACTS OF JAPAN vol. 017, no. 386 (E-1401), 20. Juli 1993 (1993-07-20) -& JP 05 067852 A (TOSHIBA CORP), 19. März 1993 (1993-03-19)
- DATABASE WPI Week 198436 Derwent Publications Ltd., London, GB; AN 1984-222938 XP002244944 -& JP 59 132698 A (FUJITSU LTD), 30. Juli 1984 (1984-07-30)
- GELLER B ET AL: "LTCC-M: AN ENABLING TECHNOLOGY FOR HIGH PERFORMANCE MULTILAYER RF SYSTEMS" MICROWAVE JOURNAL, HORIZON HOUSE. DEDHAM, US, Bd. 42, Nr. 7, Juli 1999 (1999-07), Seiten 64,66-68,70,72, XP000920411 ISSN: 0192-6225
- PATENT ABSTRACTS OF JAPAN vol. 016, no. 564 (E-1295), 4. Dezember 1992 (1992-12-04) -& JP 04 215414 A (TAIYO YUDEN CO LTD), 6. August 1992 (1992-08-06)
- PATENT ABSTRACTS OF JAPAN vol. 1999, no. 01, 29. Januar 1999 (1999-01-29) & JP 10 284836 A (HITACHI LTD), 23. Oktober 1998 (1998-10-23)
- PATENT ABSTRACTS OF JAPAN vol. 1997, no. 05, 30. Mai 1997 (1997-05-30) & JP 09 024579 A (OKI ELECTRIC IND CO LTD), 28. Januar 1997 (1997-01-28)

## Beschreibung

Die vorliegende Erfindung betrifft ein Verfahren zum Herstellen von Leiterbahnen nach dem Oberbegriff des Anspruches 1. Insbesondere befaßt sich die Erfindung mit dem Herstellen von Leiterbahnen für Mehrlagenschaltungen, die in LTCC-(Low Temperatur Cofired Ceramic)-Technik hergestellt werden.

Derartige LTCC-Mehrlagenschaltungen haben in letzter Zeit immer größere Bedeutung erlangt, da mit ihnen gegenüber der Mehrebenen-Druckplatinentechnik eine deutlich höhere Leiterbahnauflösung erzielt werden kann. Die einzelnen Trägerschichten bestehend dabei aus einer grünen, also noch nicht gesinterten Keramikfolie mit einer Dicke von ca. 130 µm. Der wesentliche Bestandteil einer derartigen Keramikfolie ist Aluminiumoxid, das mit Glasbestandteilen und weiteren Füllmaterialien vermischt ist. In einem ersten Bearbeitungsschritt wird die Keramikfolie auf die benötigten Abmessungen zugeschnitten. Anschließend werden Durchkontaktierungslöcher in die Folien gestanzt, die im zusammengesetzten Zustand der Mehrlagenschaltung unterschiedliche Leiterbahnebenen verbinden.

Nach dem Füllen der Durchkontaktierungslöcher mit einem leitfähigen Material wird - vorzugsweise mittels Siebdrucktechnik - ein Leiterbahnmuster auf die Oberfläche der Keramikfolie aufgebracht. Die Struktur einer auf die im wesentlichen ebene Oberfläche der Keramikfolie 1 aufgedruckten Leiterbahn 2 ist im Schnitt in Fig. la dargestellt. Mehrere Lagen auf diese Weise gestanzter und bedruckter Keramikfolien werden schließlich übereinander angeordnet, ausgerichtet und in einer Preßform gestapelt. Dieser Verbund wird dann zunächst unter Zuführung von Wärme und Druck laminiert und anschließend gesintert, so daß sich ein hochfester Keramikverbund mit einem geschlossenen Leiterbahnsystem über mehrere Ebenen bildet.

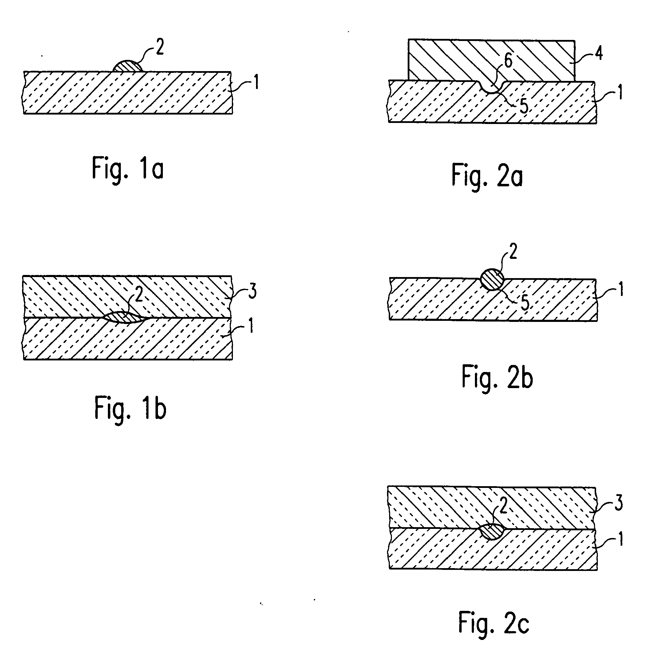

Durch das Unterdrucksetzen der Keramikschichten werden die Leiterbahnen während des Laminierens und des Sinterns platt gedrückt, so daß diese am Ende des Herstellungsprozesses der Keramik-Mehrlagenstruktur die in Fig. 1b gezeigte Form aufweisen. Wird als Leiterbahn-Material beispielsweise eine silber-haltige Leiterpaste verwendet, so werden auf diese Weise Leiterbahn-Dicken von ungefähr 15 µm erreicht.

Es ist unmittelbar einsichtig, daß der in Fig. 1b gezeigte abgeflachte Leiterbahnquerschnitt keine optimal Lösung darstellt. Beispielsweise muß darauf geachtet werden, daß die Oberflächen der einzelnen Keramikfolien 1 und 3 sehr glatt sind, da ansonsten die Gefahr besteht, daß die Leiterbahnen 2 durch Erhebungen in den Oberflächen der Keramikfolien 1 bzw. 3 unterbrochen werden. Insbesondere in den Fällen, in denen in eine Mehrlagenschaltung planare Spulen, die beispielsweise für sehr hohe Frequenzen benötigt werden, integriert werden sollen, ist eine hohe Spulengüte erwünscht. Diese wird zum einen durch ein möglicherweise vorhandenes Kernmaterial - beispielsweise Ferrit - bestimmt, zum anderen aber auch im wesentlichen durch den ohm'schen Widerstand der Leitungen. Der mit dem eben beschriebenen Verfahren erreichbare und in Fig. 1b dargestellte Leiterbahn-Querschnitt weist allerdings einen relativ hohen Widerstand auf.

Aus der JP 02 299292 A, JP 05 067852 A und JP 04 215414 A sind jeweils Verfahren zum Herstellen von Leiterbahnen in einer aus mehreren Trägerschichten, zwischen denen sich die Leiterbahnen befinden, bestehenden Mehrlagenschaltung bekannt. Die Trägerschichten werden nach dem Aufbringen eines die Leiterbahnen bildenden leitfähigen Materials unter Druck zusammengefügt. Vor dem Aufbringen des leitfähigen Materials werden Ausnehmungen entsprechend einem gewünschten Leiterbahnenmuster in die Oberfläche eingeformt und anschließend gefüllt.

Aus der Publikation *"*LTCC-M: An Enabling Technology for High Performance Multilayer RF Systems" der Autoren GELLER et.al., veröffentlicht in Microwave Journal, Horizon House. Dedham, US Band 42, Nr. 7, Juli 1999, Seite 64 bis 72 ist eine Keramikfolie bekannt, auf der Leiterbahnen im noch nicht gesinterten Zustand mittels Siebdruck aufgebracht werden. Nachteilig am derartigen Herstellungsverfahren ist, dass beim Zusammenfügen mehrerer derartiger Trägerschichten, die Leiterbahnen plattgedrückt werden, wodurch die Leiterbahnen einen hohen ohmschen Verlustwiderstand aufweisen.

Es ist daher Aufgabe der vorliegenden Erfindung, ein Verfahren zum Herstellen von Leiterbahnen auf Trägerschichten anzugeben, bei dem mit geringem Aufwand Leiterbahnen mit einem möglichst geringem ohm'schen Widerstand hergestellt werden können.

Die Aufgabe wird durch ein Verfahren, das die Merkmale des Anspruches 1 aufweist, gelöst. Erfindungsgemäß wird vorgeschlagen, vor dem Aufbringen des die Leiterbahnen bildenden leitfähigen Materials entsprechend dem gewünschten Leiterbahn-Muster Ausnehmungen in die Oberfläche einer Trägerschicht einzuformen und diese anschließend mit dem leitfähigen Material zu füllen. Diese Ausnehmungen sind im Querschnitt kreisabschnitt-artig. Allerdings wären auch trapezförmige oder anders geformte Ausnehmungen denkbar, durch die ebenfalls ein günstiges Verhältnis von Querschnittsfläche zu Umfang erzielt werden kann. Durch das Vorformen der Oberfläche der Trägerschicht wird erreicht, daß die Leiterbahnen auch nach dem Zusammenfügen mehrerer Trägerschichten unter Druck eine relativ hohe Dicke aufweisen und im Idealfall im Querschnitt kreisförmig sind. Bei vorgegebener Querschnittsfläche, die durch die Menge der aufgetragenen Leiterpaste bestimmt wird, ist ein kreisförmiger Querschnitt jedoch für einen geringstmöglichen Widerstand am günstigsten. Ferner wird durch das erfindungsgemäße Verfahren die Gefahr, daß durch Unebenheiten in der Oberfläche einer Trägerschicht eine Leiterbahn unterbrochen werden könnte, deutlich reduziert.

Das erfindungsgemäße Verfahren ist insbesondere bei der Verwendung von niedrig sinternden Keramikfolien zur Herstellung einer LTCC-Mehrlagenschaltung geeignet. Vorzugsweise werden dabei die Ausnehmungen durch Prägen in die Oberfläche der verschiedenen Keramikfolien geformt. Dabei weist der für dieses Verfahren verwendete Prägestempel dem gewünschten Leiterbahn-Muster entsprechende Vorwölbungen auf, welche im Querschnitt ebenfalls vorzugsweise kreisabschnitt-artig - beispielsweise halbkreisförmig - sind. Das Formen der Ausnehmungen durch Prägen ist auch sehr einfach und schnell durchzuführen.

Im folgenden soll die Erfindung anhand der beiliegenden Zeichnung näher erläutert werden. Es zeigen:
- Fig. 1a: einen ersten Arbeitsschritt eines herkömmlichen Verfahrens zum Herstellen von Leiterbahnen;
- Fig. 1b: die Struktur einer nach dem herkömmlichen Verfahren hergestellten Leiterbahn im Schnitt;
- Fig. 2a: das Formen von kreisabschnitt-artigen Ausnehmungen in die Oberfläche einer Trägerschicht entsprechend der vorliegenden Erfindung;
- Fig. 2b: die mit einem leitfähigen Material gefüllte Ausnehmung; und
- Fig. 2c: die Struktur einer nach dem erfindungsgemäßen Verfahren hergestellten Leiterbahn im Schnitt.

Die Figuren la und 1b, welche ein bekanntes Verfahren zum Herstellen von Leiterbahnen 2 darstellen, wurden bereits erläutert. Der erste Schritt des erfindungsgemäßen Verfahrens ist in Fig. 2a dargestellt. Dabei wird ein Prägestempel 4, der im Querschnitt halbkreisförmige Vorwölbungen 6 aufweist, auf eine Keramikfolie 1 aufgesetzt, wodurch in die Oberfläche der Keramikfolie 1 im Schnitt halbkreisförmige Ausnehmungen 5 geformt werden. Die Struktur der Vorwölbungen 6 auf der Unterseite des Prägestempels 4 entspricht dabei dem gewünschten Leiterbahnmuster für Keramikfolie 1.

Anschließend werden die Ausnehmungen 5 mittels Siebdrucktechnik mit einer Leiterpaste gefüllt. Vorzugsweise werden dafür Silber-, Silber/Paladium-, Gold- oder Kupferpasten verwendet. Durch das vorherige Bearbeiten der Oberfläche der Keramikfolie 1 entstehen nach dem Aufdruck der Leiterpaste im Schnitt kreisförmige Leiterbahnen 2.

Werden dann im abschließenden und in Fig. 2c dargestellten Bearbeitungsschritt mehrere Keramikfolien 1 und 3 übereinander angeordnet und zusammengepreßt, werden die Leiterbahnen 2 nur geringfügig platt gedrückt, so daß sich der in Fig. 2c dargestellte Querschnitt ergibt.

Bei einem Vergleich mit der Struktur der Leiterbahn 2 in Fig. 1b wird deutlich, daß bei der gleichen Menge von aufgetragenem Leiterbahn-Material, was bedeutet, daß die Querschnittsfläche der Leiterbahnen 2 in den Fig. 1b und 2c gleich groß ist, die in Fig. 2c dargestellte Leiterbahn 2 deutlich höher und kreisförmiger ist als die nach dem herkömmlichen Verfahren hergestellten Leiterbahn in Fig. 1b. Die vorliegende Erfindung ermöglicht somit die Herstellung von Leiterbahnen, die einen reduzierten ohm'schen Widerstand aufweisen.

Das Formen der Ausnehmungen in die Oberfläche der Keramikfolien kann mit einem der weiteren Bearbeitungsschritte kombiniert werden. Beispielsweise wäre es möglich, das Zuschneiden der Einzelfolien auf die benötigten Abmessungen und das Prägen der Ausnehmungen in einem gemeinsamen Arbeitsschritt durchzuführen. Andererseits wäre es auch denkbar, das Ausstanzen der Durchkontaktierungslöcher und das Einprägen der Ausnehmungen zu kombinieren. In diesem Fall wäre ein geeigneter Stempel denkbar, der einerseits die erfindungsgemäßen Vorwölbungen und andererseits die entsprechenden Stanzen aufweist. Auf diese Weise wird auch durch den zusätzlichen Arbeitsschritt die Herstellungsgeschwindigkeit von LTCC-Strukturen nur unwesentlich - wenn überhaupt - verlangsamt. Gegenüber den bisher bekannten Verfahren kann jedoch in einfacher Weise mit der gleichen Materialmenge eine Leiterbahn deutlich höherer Qualität hergestellt werden.

## Patentansprüche

1. Verfahren zum Herstellen von Leiterbahnen (2) in einer aus mehreren Trägerschichten (1, 3), zwischen denen sich die Leiterbahnen (2) befinden, bestehenden Mehrlagenschaltung, bei dem die Trägerschichten (1, 3) nach dem Aufbringen eines die Leiterbahnen (2) bildenden leitfähigen Materials unter Druck zusammengefügt werden, wobei vor dem Aufbringen des leitfähigen Materials in die Oberfläche einer Trägerschicht (1) entsprechend dem gewünschten Leiterbahnmuster Ausnehmungen (5) eingeformt werden und diese anschließend mit dem leitfähigen Material gefüllt werden, **dadurch gekennzeichnet, dass** es sich bei den Trägerschichten um niedrig sinternde Keramikfolien (1, 3) handelt, auf die im noch nicht gesinterten Zustand die Leiterbahnen (2) mittels Siebdruck aufgebracht werden und die anschließend unter Druck zusammengefügt und gesintert werden,
wobei die Leiterbahnen (2, 3) im Schnitt kreisförmig sind und über die Oberfläche einer Trägerschicht (1) hinausstehen.

2. Verfahren nach Anspruch 1,
**dadurch gekennzeichnet,**
**dass** die Ausnehmungen (5) durch Prägen in die Oberfläche der Keramikfolien (1) eingeformt werden.

3. Verfahren nach einem der Ansprüche 1 oder 2,
**dadurch gekennzeichnet,**
**dass** die Ausnehmungen (5) im Querschnitt kreisabschnitt-artig sind.

## Claims

1. Process for manufacturing conductive lines (2) in a multilayer circuit consisting of multiple carrier layers (1, 3), between which the conductive lines (2) are located, in which process the carrier layers (1, 3) are joined together under pressure after the application of a conductive material forming the conductive lines (2), wherein, before the application of the conductive material, recesses (5) are formed in the surface of a carrier layer (1) in a way corresponding to the desired pattern of the conductive lines and these recesses are subsequently filled with the conductive material, **characterized in that** the carrier layers are low-sintering ceramic sheets (1, 3), to which, in the not yet sintered state, the conductive lines (2) are applied by means of screen printing and which are subsequently joined together under pressure and sintered, wherein the conductive lines (2, 3) are circular in section and protrude beyond the surface of a carrier layer (1).

2. Process according to Claim 1, **characterized in that** the recesses (5) are formed into the surface of the ceramic sheet (1) by stamping.

3. Process according to either of Claims 1 and 2, **characterized in that** the recesses (5) are like segments of a circle in cross section.

## Revendications

1. Procédé de production de pistes conductrices (2) dans un circuit multicouche composé de plusieurs couches de support (1, 3), entre lesquelles se trouvent les pistes conductrices (2), dans lequel les couches de support (1, 3) sont assemblées sous pression après l'application d'un matériau conducteur formant les pistes conductrices (2),
dans lequel, avant l'application du matériau conducteur, des évidements (5) sont formés dans la surface d'une couche de support (1) conformément au motif de piste conductrice souhaité et ceux-ci sont ensuite remplis avec le matériau conducteur, **caractérisé en ce que** les couches de support sont des feuilles céramiques à faible frittage (1, 3), sur lesquelles, à l'état non encore fritté, les pistes conductrices (2) sont appliquées par sérigraphie et qui sont ensuite assemblées sous pression et frittées, dans lequel les pistes conductrices (2, 3) sont, en coupe, de forme circulaire et font saillie au-delà de la surface d'une couche de support (1).

2. Procédé selon la revendication 1,
**caractérisé en ce que**
les évidements (5) sont formés par gaufrage dans la surface des feuilles céramiques (1).

3. Procédé selon l'une des revendications 1 ou 2,
**caractérisé en ce que**
les évidements (5) sont, en coupe transversale, de type en segment circulaire.
